# FASCICULE DE BREVET EUROPEEN

(11) **EP 3 175 487 B1**
(45) Date de publication et mention de la délivrance du brevet: **31.03.2021**
(21) Numéro de dépôt: 15741564.7
(22) Date de dépôt: 27.07.2015
(51) Int. Cl.: H01L 31/048, H02S 20/20

(54) **MODULE PHOTOVOLTAÏQUE COMPORTANT UNE FACE AVANT EN POLYMÈRE**
FOTOVOLTAIKMODUL MIT EINER POLYMERVORDERSEITE
PHOTOVOLTAIC MODULE COMPRISING A POLYMER FRONT FACE

(30) Priorité: 28.07.2014 FR 1457278
(43) Date de publication de la demande: 07.06.2017
(73) Titulaire: Commissariat à l'Énergie Atomique et aux Énergies Alternatives, 75015 Paris (FR); Arkema France, 92700 Colombes (FR)
(72) Inventeur: HIDALGO, Manuel, 69530 Brignais (FR); GAUME, Julien, 38110 La Tour Du Pin (FR); GUILLEREZ, Stéphane, 73610 Lepin Le Lac (FR); SICOT, Lionel, 73000 Chambery (FR)
(74) Mandataire: Brevalex
(86) Numéro de dépôt international: PCT/EP2015/067108
(87) Numéro de publication internationale: WO 2016/016164

(56) Documents cités:
- FR-A1- 2 244 266
- US-A1- 2007 131 274
- US-A1- 2010 154 867
- US-A1- 2012 260 975
- US-A1- 2014 000 683
- US-A1- 2014 182 658
- Dominique Jousset ET AL: "Nanostructured copolymers : bloc copolymers (Nanostrength ) and grafted copolymers (Apolhya ) INNOV'DAYS LES NANOMATERIAUX EN PLASTURGIE 22 novembre 2012 - Dijon", INNOV'DAYS LES NANOMATERIAUX EN PLASTURGIE, 22 novembre 2012 (2012-11-22), page 22, XP055181464, Dijon Extrait de l'Internet: URL:http://www.innovdays-plasturgie.com/in novdays/Illustrations/Documents/InnovDays/ 2012/20121122_Nanomateriaux/5_ARKEMA-Apolh ya_nov12.pdf [extrait le 2015-04-08]
- Jean-Marc Boutillier: "NOUVELLE GENERATION DE PMMA NANOSTRUCTURE : ALTUGLAS SHIELDUP", INNOV'DAYS Les Plastiques Transparents, 29 mars 2012 (2012-03-29), XP055181454, Lyon Extrait de l'Internet: URL:http://www.innovdays-plasturgie.com/in novdays/Illustrations/Documents/InnovDays/ 2012/20120329_Plastiques_Transparents/3_AR KEMA_LACQ_mars2012.pdf [extrait le 2015-04-08]

## Description

### DOMAINE TECHNIQUE

La présente invention se rapporte au domaine des modules photovoltaïques, comportant un ensemble de cellules photovoltaïques reliées entre elles électriquement, et notamment des cellules photovoltaïques dites « cristallines », c'est-à-dire qui sont à base de cristaux de silicium ou de polycristaux de silicium.

L'invention peut être mise en œuvre pour de nombreuses applications, étant particulièrement concernée par les applications qui requièrent l'utilisation de modules photovoltaïques légers, flexibles et robustes vis-à-vis de chocs et de charges mécaniques élevées. Elle peut ainsi notamment être appliquée pour des bâtiments tels que des habitats ou locaux industriels, par exemple pour la réalisation de leurs toitures, pour la conception de mobilier urbain, par exemple pour de l'éclairage public, la signalisation routière ou encore la recharge de voitures électriques, ou également pour son intégration sur des zones circulables, pour des piétons et/ou des véhicules, telles que des chaussées ou routes, des pistes cyclables, des plateformes industrielles, des places, des trottoirs, entre autres.

L'invention propose ainsi un module photovoltaïque muni d'une face avant en polymère, un ensemble de structure photovoltaïque comportant un tel module photovoltaïque, l'utilisation d'un tel module photovoltaïque pour son application sur un support rigide, ainsi qu'un procédé de réalisation d'un tel module ou d'un tel ensemble de structure photovoltaïque.

### ÉTAT DE LA TECHNIQUE ANTÉRIEURE

Un module photovoltaïque est un assemblage de cellules photovoltaïques disposées côte à côte entre une première couche transparente formant une face avant du module photovoltaïque et une seconde couche formant une face arrière du module photovoltaïque.

La première couche formant la face avant du module photovoltaïque est avantageusement transparente pour permettre aux cellules photovoltaïques de recevoir un flux lumineux. Elle est traditionnellement réalisée en une seule plaque de verre, présentant une épaisseur de l'ordre de 3 mm. La deuxième couche formant la face arrière du module photovoltaïque peut quant à elle être réalisée à base de verre, de métal ou de plastique, entre autres. Elle est habituellement formée par une structure polymérique à base d'un polymère isolant électrique, par exemple du type polytéréphtalate d'éthylène (PET) ou polyamide (PA), pouvant être protégée par une ou des couches à base de polymères fluorés, comme le polyfluorure de vinyle (PVF) ou le polyfluorure de vinylidène (PVDF), et ayant une épaisseur de l'ordre de 300 µm.

Les cellules photovoltaïques peuvent être reliées électriquement en série entre elles par des éléments de contact électrique avant et arrière, appelés conducteurs de liaison, et formés par exemple par des bandes de cuivre, respectivement disposées contre les faces avant (faces se trouvant en regard de la face avant du module photovoltaïque destinée à recevoir un flux lumineux) et arrière (faces se trouvant en regard de la face arrière du module photovoltaïque) de chacune des cellules photovoltaïques.

Par ailleurs, les cellules photovoltaïques, situées entre les première et deuxième couches formant respectivement les faces avant et arrière du module photovoltaïque, sont encapsulées. De façon classique, l'encapsulant choisi correspond à un polymère du type élastomère (ou caoutchouc), et peut par exemple consister en l'utilisation de deux couches (ou films) de poly(éthylène-acétate de vinyle) (EVA) entre lesquelles sont disposées les cellules photovoltaïques et les conducteurs de liaison des cellules. Chaque couche d'EVA peut présenter une épaisseur d'au moins 0,3 mm et un module de Young inférieur ou égal à 30 MPa à température ambiante.

Habituellement encore, le procédé de réalisation du module photovoltaïque comporte une seule étape de laminage des différentes couches décrites précédemment, à une température supérieure ou égale à 140°C, voire 150°C, et pendant une période d'au moins 8 minutes, voire 15 minutes. Après cette opération de laminage, les deux couches d'EVA ont fondu pour ne former qu'une seule couche dans laquelle sont noyées les cellules photovoltaïques.

Néanmoins, ces réalisations connues de l'art antérieur d'un module photovoltaïque ne sont pas entièrement satisfaisantes et présentent plusieurs inconvénients pour au moins certaines de leurs applications.

Ainsi, tout d'abord, la présence d'une plaque de verre pour former la face avant du module photovoltaïque n'est pas compatible avec certaines applications du module photovoltaïque qui peuvent requérir une relative légèreté et une facilité de mise en forme du module. Au contraire, les conceptions de l'art antérieur utilisant du verre en face avant des modules photovoltaïques impliquent l'obtention d'un poids élevé du module et une capacité d'intégration limitée.

Des solutions ont été envisagées pour remplacer la face avant en verre des modules photovoltaïques par des matériaux plastiques, tout en conservant l'architecture et la méthode de réalisation classiques des modules photovoltaïques. A titre d'exemples, la demande de brevet FR 2 955 051 A1 et les demandes internationales WO 2012/140585 A1 et WO 2011/028513 A2 décrivent des possibilités d'alternatives au verre pour concevoir la face avant des modules photovoltaïques, parmi lesquelles l'utilisation de feuilles de polymère, d'une épaisseur inférieure ou égale à 500 µm, comme le polyfluorure de vinylidène (PVDF), l'éthylène tétrafluoroéthylène (ETFE), le polyméthacrylate de méthyle (PMMA) ou encore le polycarbonate (PC).

Cependant, la simple substitution du verre par un matériau polymère, afin d'obtenir un module photovoltaïque léger et flexible, entraîne généralement une vulnérabilité accrue du module aux chocs et aux charges mécaniques, non acceptable pour certaines applications.

De plus, dans ces exemples de réalisation de l'art antérieur, la face avant (dépourvue de verre) de chaque module photovoltaïque est continue, c'est-à-dire qu'elle forme une feuille ou une plaque unitaire qui recouvre l'ensemble du module. De la sorte, la flexibilité de chaque module photovoltaïque peut être limitée et surtout non suffisante. Par ailleurs, cela pose également un problème d'accentuation de contraintes différentielles de dilatation entre les différentes couches de la structure, pouvant conduire à des déformations ou des décollements indésirables aux interfaces de la structure, comme par exemple à l'interface encapsulant/couches externes.

Il a été proposé certaines solutions visant à obtenir une relative discontinuité de la face avant d'un module photovoltaïque afin d'obtenir une meilleure flexibilité du module et de mieux gérer les contraintes de dilatation différentielle. Ainsi, par exemple, la demande de brevet US 2014/0000683 A1 décrit une méthode pour encapsuler des cellules photovoltaïques de manière individuelle. Les cellules encapsulées peuvent ensuite être interconnectées pour obtenir un module photovoltaïque souple. Par ailleurs, la demande de brevet US 2014/0030841 A1 enseigne la mise en œuvre d'un module photovoltaïque sur un substrat flexible. Le module photovoltaïque est composé de « sous-modules » constitués de cellules photovoltaïques interconnectées, chaque sous-module étant indépendant électriquement des sous-modules voisins. La demande de brevet US 2007/0131274 A1 décrit encore un autre exemple de module photovoltaïque pouvant comporter une face avant discontinue.

Toutefois, les solutions décrites ci-dessus ne s'avèrent pas totalement satisfaisantes en termes de flexibilité, de résistance aux chocs et aux charges mécaniques, de performance et de coût des modules photovoltaïques, notamment pour des applications contraignantes qui les sollicitent fortement au niveau de leur résistance mécanique. En particulier, les matériaux utilisés dans les réalisations de modules photovoltaïques selon l'art antérieur ne sont pas suffisamment satisfaisants pour répondre à de telles contraintes.

### EXPOSÉ DE L'INVENTION

Il existe ainsi un besoin pour proposer une solution alternative de conception d'un module photovoltaïque pour répondre à au moins certaines contraintes inhérentes aux applications visées par l'utilisation du module photovoltaïque, en particulier pour améliorer la flexibilité, la rigidité, la légèreté, la planéité et la résistance aux chocs et charges mécaniques du module photovoltaïque.

L'invention a pour but de remédier au moins partiellement aux besoins mentionnés ci-dessus et aux inconvénients relatifs aux réalisations de l'art antérieur.

L'invention a ainsi pour objet, selon l'un de ses aspects, un module photovoltaïque comportant au moins :
- une première couche transparente formant la face avant du module photovoltaïque destinée à recevoir un flux lumineux,
- un ensemble d'une pluralité de cellules photovoltaïques disposées côte à côte et reliées électriquement entre elles,
- un ensemble encapsulant la pluralité de cellules photovoltaïques,
- une deuxième couche formant la face arrière du module photovoltaïque, l'ensemble encapsulant et l'ensemble d'une pluralité de cellules photovoltaïques étant situés entre les première et deuxième couches,
caractérisé en ce que la première couche est constituée d'au moins un matériau polymère transparent, et comporte une pluralité de plaques indépendantes les unes des autres, chaque plaque étant située en regard d'au moins une cellule photovoltaïque, de sorte à former une face avant discontinue du module photovoltaïque,
et en ce que la rigidité de l'ensemble encapsulant est définie par un module de Young du matériau d'encapsulation supérieur ou égal à 75 MPa à température ambiante et une épaisseur de l'ensemble encapsulant comprise entre 0,4 et 1 mm.

Ledit au moins un matériau polymère transparent constitutif de la premier couche fait avantageusement partie des copolymères à blocs acryliques ou d'une composition comprenant au moins un copolymère à blocs acryliques ayant la formule générale suivante :

(A)ₙB

dans laquelle :
- n est un nombre entier supérieur ou égal à 1 ;
- A est un homo- ou copolymère acrylique ou méthacrylique ayant une température de transition vitreuse Tg supérieure à 50°C, de préférence supérieure à 80°C, ou du polystyrène, ou un copolymère acrylique-styrène ou méthacrylique-styrène ; et
- B est un homo- ou copolymère acrylique ou méthacrylique ayant une température de transition vitreuse Tg inférieure à 20°C, préférentiellement composé d'acrylate de méthyle, d'acrylate d'éthyle, d'acrylate d'éthylhexyl, de méthacrylate de butyle, et plus préférentiellement d'acrylate de butyle.

Plus précisément, lorsque A est un homo- ou copolymère méthacrylique (majoritairement méthacrylique ou acrylique à majorité de méthyl méthacrylate), ledit au moins un matériau polymère transparent constitutif de la première couche est alors avantageusement du polyméthacrylate de méthyle (PMMA) choc nanostructuré.

Lorsque A est du polystyrène, ou un copolymère acrylique-styrène ou méthacrylique-styrène, ledit au moins un matériau polymère transparent constitutif de la première couche fait partie des copolymères à blocs acryliques ou d'une composition comprenant au moins un copolymère à blocs acryliques car B est un homo- ou copolymère acrylique ou méthacrylique, mais alors ledit au moins un matériau polymère transparent constitutif de la première couche n'est pas du polyméthacrylate de méthyle (PMMA) choc nanostructuré.

Initialement, c'est-à-dire avant toute opération de laminage, l'ensemble encapsulant est constitué par deux couches de matériau d'encapsulation, dites couches de cœur, entre lesquelles l'ensemble d'une pluralité de cellules photovoltaïques est encapsulé. Toutefois, après l'opération de laminage des couches, les couches de matériau d'encapsulation ont fondu pour ne former qu'une seule couche (ou ensemble) dans laquelle sont noyées les cellules photovoltaïques. Avant toute opération de laminage, chaque couche de matériau d'encapsulation peut ainsi présenter une rigidité définie par un module de Young du matériau d'encapsulation supérieur ou égal à 75 MPa à température ambiante et une épaisseur de la couche comprise entre 0,2 et 1 mm, voire entre 0,2 et 0,5 mm.

L'ensemble encapsulant la pluralité de cellules photovoltaïques est ainsi constitué par les deux couches de cœur, à savoir les couches de matériau d'encapsulation qui avant laminage sont en contact direct avec les cellules photovoltaïques, et ne comprend donc pas la ou les couches additionnelles pouvant être utilisées pour former un gradient de rigidité, comme décrit par la suite.

Le terme « transparent » signifie que le matériau de la première couche formant la face avant du module photovoltaïque est au moins partiellement transparent à la lumière visible, laissant passer au moins environ 80 % de cette lumière.

De plus, par l'expression « plaques indépendantes les unes des autres », on entend que les plaques sont situées à distance les unes des autres, formant chacune un élément unitaire indépendant de la première couche et les uns des autres, superposé à au moins une cellule photovoltaïque. La réunion de l'ensemble de ces plaques forme alors la première couche avec un aspect discontinu.

En outre, par le terme « encapsulant » ou « encapsulé », il faut comprendre que l'ensemble d'une pluralité de cellules photovoltaïques est disposé dans un volume, par exemple hermétiquement clos, au moins en partie formé par les deux couches de matériau d'encapsulation, réunies entre elles après laminage.

Par ailleurs, par l'expression « température ambiante », on entend une température comprise entre environ 15 et 30°C.

Grâce à l'invention, il peut ainsi être possible d'apporter une solution alternative pour la conception d'un module photovoltaïque souple et relativement flexible, présentant une planéité satisfaisante (absence de gauchissement) et également suffisamment robuste pour résister à des chocs et des charges mécaniques subis, par exemple après application sur un support rigide, même en l'absence d'utilisation du verre en face avant du module qui assure habituellement la planéité et la résistance mécanique d'un module photovoltaïque traditionnel, notamment par le biais de l'utilisation de matériaux spécifiques pour la réalisation des différentes couches du module. En particulier, l'utilisation d'une face avant discontinue peut conférer au module photovoltaïque selon l'invention un caractère flexible permettant notamment de faciliter son application sur un support non plan, par exemple courbé. De plus, l'utilisation d'un matériau d'encapsulation de rigidité élevée de part et d'autre des cellules photovoltaïques peut permettre de protéger convenablement les cellules photovoltaïques contre le risque d'une forte charge mécanique ou d'un choc, en limitant leur flexion, et donc en limitant le risque de cassure. En outre, l'absence d'usage d'un matériau en verre pour la face avant du module photovoltaïque peut permettre au module photovoltaïque selon l'invention de présenter un poids inférieur à celui d'un module photovoltaïque selon l'art antérieur, typiquement de l'ordre de 12 kg/m², en fonction de l'épaisseur des différentes couches utilisées. Enfin, l'utilisation d'une face avant discontinue en un matériau polymère peut permettre de se prémunir de problèmes de dilatation thermique au cours de l'emploi du module photovoltaïque selon l'invention en extérieur. En effet, la dilatation thermique étant proportionnelle aux dimensions de la première couche formant la face avant du module, le fait d'utiliser des plaques ayant des dimensions proches de celles des cellules photovoltaïques peut permettre de limiter significativement les déplacements induits par des contraintes thermiques pouvant donner lieu à des délaminations ou une conformation non contrôlée du module photovoltaïque.

Le module photovoltaïque selon l'invention peut en outre comporter l'une ou plusieurs des caractéristiques suivantes prises isolément ou suivant toutes combinaisons techniques possibles.

Le module photovoltaïque peut être ou non appliqué sur un support rigide, par exemple par collage. Un tel support rigide peut être de tout type, par exemple lisse, poreux, plat ou courbé. Un tel support rigide peut par exemple être utilisé lorsque le module photovoltaïque doit être soumis à de fortes charges mécaniques, par exemple des pressions statiques ou dynamiques pouvant aller jusqu'à 1500 kN/m², voire 5000 kN/m².

La première couche formant la face avant du module photovoltaïque peut être monocouche ou multicouche. En particulier, elle peut comporter un ensemble de couches transparentes superposées entre elles.

La deuxième couche formant la face arrière du module photovoltaïque peut également être discontinue. Autrement dit, la deuxième couche peut également comporter une pluralité de plaques indépendantes les unes des autres, chaque plaque étant située en regard, c'est-à-dire superposée, d'au moins une cellule photovoltaïque. La présence d'une face arrière discontinue sur le module photovoltaïque selon l'invention peut par exemple permettre d'améliorer encore la flexibilité du module, par exemple pour faciliter son application sur un support rigide pourvu d'une rugosité de surface.

Par ailleurs, quand bien même la première couche formant la face avant du module photovoltaïque selon l'invention, et éventuellement la deuxième couche formant la face arrière du module, présentent un aspect discontinu, l'ensemble d'une pluralité de cellules photovoltaïques et l'ensemble encapsulant sont avantageusement continues.

Selon un mode de réalisation particulier de l'invention, chaque plaque de la première couche, et éventuellement de la deuxième couche, peut être située en regard de plusieurs cellules photovoltaïques. Cela peut notamment être le cas pour des cellules photovoltaïques de dimensions plus faibles que celles des cellules photovoltaïques classiques, typiquement de 156 x 156 mm.

De plus, lorsqu'une seule cellule photovoltaïque est située en regard de chaque plaque de la première couche, et éventuellement de la deuxième couche, chaque plaque peut présenter des dimensions au moins égales à celles de la cellule photovoltaïque à laquelle elle est superposée.

Le module photovoltaïque est avantageusement dépourvu d'une première couche formant la face avant du module réalisée en verre. Ainsi, comme indiqué précédemment, il peut être possible d'améliorer la légèreté et la capacité d'intégration du module photovoltaïque.

Comme indiqué précédemment, ledit au moins un matériau polymère transparent constitutif de la première couche peut avantageusement être du polyméthacrylate de méthyle (PMMA) choc nanostructuré, notamment tel que celui commercialisé par la société ARKEMA sous la marque ShieldUp®.

Le PMMA choc nanostructuré peut être tel que celui décrit dans la demande internationale WO 03/062293 A1, la demande internationale WO 2006/061523 A1 ou encore la demande internationale WO 2012/085487 A1.

Préférentiellement, le bloc A est du polyméthacrylate de méthyle, du polyméthacrylate de phényle, du polyméthacrylate de benzyle ou du polyméthacrylate d'isobornyle, ou un copolymère à base de deux ou plus des monomères méthacrylate de méthyle, méthacrylate de phényle, méthacrylate de benzyle, méthacrylate d'isobornyle. Préférentiellement encore, le bloc A est du PMMA modifié avec des comonomères acryliques ou méthacryliques.

Par ailleurs le bloc A et/ou le bloc B peuvent comporter des comonomères styréniques, tels que le styrène, acryliques ou méthacryliques, porteurs de fonctions chimiques diverses connues de l'Homme du métier, par exemple des fonctions acide, amide, amine, hydroxy, époxy ou alcoxy.

Le bloc B peut de manière préférée incorporer des comonomères, tels que le styrène, pour améliorer la transparence. De plus, le bloc A peut incorporer de l'acide méthacrylique afin d'en augmenter la tenue thermique.

Avantageusement, l'utilisation du PMMA choc nanostructuré peut permettre d'apporter à la structure multicouche que forme le module photovoltaïque une bonne résistance aux charges mécaniques et aux chocs, supérieure à celle du PMMA classique (i.e. non choc et non nanostructuré), tout en permettant également de conserver une plus grande transparence que le PMMA choc classique (i.e. non nanostructuré) dans la zone de températures comprise entre 30°C et 90°C. Ainsi, l'utilisation du PMMA choc nanostructuré pour la première couche formant la face avant du module photovoltaïque peut permettre de profiter d'un très bon compromis entre résistance mécanique, notamment au choc, transparence, transparence en fonction de la température et tenue au vieillissement. Au contraire, le polycarbonate, qui possède de bonnes propriétés en termes de transparence et de tenue au choc, présente une très mauvaise tenue au vieillissement extérieur. Le PMMA non choc et non nanostructuré, qui présente une très bonne transparence et une très bonne tenue au vieillissement, résiste mal au choc. De même, le PMMA choc non nanostructuré, qui présente une bonne résistance au choc et une bonne tenue au vieillissement, perd sa transparence dès que la température augmente et avoisine la zone comprise entre 30 et 90°C, qui constitue une zone habituelle de températures pour des modules photovoltaïques.

Comme indiqué auparavant, l'ensemble encapsulant est formé, notamment avant laminage, par deux couches de matériau d'encapsulation de cœur situées à proximité immédiate de l'ensemble de cellules photovoltaïques, respectivement de part et d'autre de l'ensemble de cellules photovoltaïques. Cet ensemble encapsulant peut être complété, notamment avant laminage, par une ou plusieurs autres couches de matériau d'encapsulation additionnelles, la rigidité de la ou des couches de matériau d'encapsulation additionnelles, autres que les deux couches de matériau d'encapsulation de cœur, étant décroissante en éloignement de l'ensemble encapsulant.

Ainsi, le module peut par exemple comporter au moins une couche de matériau d'encapsulation additionnelle, située entre la première couche formant la face avant du module photovoltaïque et la couche de matériau d'encapsulation de cœur à proximité immédiate.

Les deux couches de matériau d'encapsulation de cœur peuvent présenter un module de Young supérieur à 100 MPa, et de préférence supérieur ou égal à 200 MPa à température ambiante. Ladite au moins une couche de matériau d'encapsulation additionnelle peut quant à elle présenter un module de Young strictement inférieur à 75 MPa à température ambiante.

Autrement dit, de façon avantageuse, le module photovoltaïque est formé à partir de couches de matériau d'encapsulation formant un empilement de couches dans lequel un dégradé ou gradient de rigidité est établi depuis les couches de matériau d'encapsulation de cœur en contact avec l'ensemble de cellules photovoltaïques jusqu'à la ou aux couches de matériau d'encapsulation additionnelles les plus éloignées des couches de cœur.

La ou les couches de matériau d'encapsulation additionnelles peuvent être situées au-dessus et/ou au-dessous de l'ensemble de cellules photovoltaïques, et plus préférentiellement au-dessus de l'ensemble de cellules photovoltaïques, c'est-à-dire entre la première couche et l'ensemble de cellules photovoltaïques.

De façon préférentielle, une ou plusieurs couches de matériau d'encapsulation additionnelles, formées par des matériaux d'encapsulation distincts de celui ou de ceux constituant les couches de cœur, sont situées au-dessus de l'ensemble de cellules photovoltaïques, au contact de la couche de matériau d'encapsulation de cœur supérieure. En effet, cela peut permettre de limiter l'épaisseur des couches situées au-dessous de l'ensemble de cellules photovoltaïques pour éviter un risque de fléchissement de cette zone du module, et également de limiter les coûts de matière du module photovoltaïque.

La ou les couches de matériau d'encapsulation additionnelles peuvent être notamment constituées d'un matériau choisi parmi les polyoléfines thermoplastiques.

Parmi ces polyoléfines thermoplastiques, il peut notamment être possible d'utiliser les encapsulants de cellules solaires de la société Dow, tels que les grades de la gamme Enlight®, ou de la société DNP.

La ou les couches de matériau d'encapsulation additionnelles peuvent notamment être constituées par des polyoléfines thermoplastiques fonctionnelles à base de greffons de polyamide, greffés sur un squelette polyoléfine fonctionnelle majoritaire en motifs éthylène, et notamment constituées par les polyoléfines thermoplastiques de la gamme Apolhya® Solar Film de la société Arkema, présentant un module de Young à température ambiante compris entre 50 et 100 MPa.

Les polyoléfines thermoplastiques fonctionnelles de la gamme Apolhya® Solar Film peuvent faire partie de la famille des copolymères greffés, aussi appelés copolymères à peigne, dans laquelle des chaînes macromoléculaires de type polyoléfine fonctionnelle constituant la structure principale ou squelette ou « corps du peigne », sont greffées par des chaînons latéraux ou greffons ou dents du peigne, de structure non polyoléfinique. Plus particulièrement, les copolymères greffés ou à peigne de la gamme Apolhya® Solar Film, sont constitués de chaînes principales d'une polyoléfine fonctionnelle sur lesquelles on vient greffer des chaînons en polyamide ou polyester (dents du peigne ou greffons). De manière encore plus particulière, les chaînes principales d'une polyoléfine fonctionnelle greffable sont des copolymères majoritaires en motifs éthylène comprenant des motifs fonctionnels, c'est-à-dire ayant d'autres fonctions chimiques différentes des motifs hydrocarbonnés. Au moins une partie de ces motifs fonctionnels présente une réactivité chimique vis-à-vis de groupes fonctionnels terminaux des greffons (ou dents de peigne). Ainsi, parmi les motifs fonctionnels réactifs, on peut citer, par exemple, les groupes acide, ester ou anhyidride. La réaction de ces motifs réactifs avec les motifs terminaux des greffons permet l'obtention de la structure chimique finale du matériau polyoléfine fonctionnelle greffée. Les greffons sont de leur côté constitués de homo- ou copolymères choisis parmi les familles des polyamides et des polyesters, ayant un seul bout terminal réactif avec les motifs fonctionnels réactifs des chaînes principales de polyoléfine fonctionnelle. De manière préférée, les greffons sont constitués d'homo- ou de copolymères de type polyamide terminés mono amine.

De tels matériaux, sous forme de feuilles ou de films, peuvent à la fois présenter une rigidité suffisante, supérieure à celle des feuilles ou films d'éthylène-acétate de vinyle (EVA) traditionnel, et une meilleure tenue au vieillissement que celui-ci.

Par ailleurs, et de manière indépendante, lorsqu'une ou plusieurs couches de matériau d'encapsulation additionnelles sont employées, permettant d'établir un gradient de rigidité entre les couches de matériau d'encapsulation de cœur à haute rigidité et la ou les couches les plus externes en contact avec la face avant ou la face arrière du module photovoltaïque, ces couches sont à rigidité moins élevée que la rigidité des couches de matériau d'encapsulation de cœur.Cela peut permettre d'assouplir la structure pour mieux encaisser mécaniquement les dilatations différentielles, en particulier lorsque la face avant et/ou la face arrière du module ont une rigidité importante de par leur épaisseur et/ou le module mécanique des matériaux employés. En effet, en l'absence d'une ou de plusieurs couches de matériau d'encapsulation additionnelles, le module photovoltaïque peut être relativement rigide, ce qui compte-tenu des différences des coefficients de dilatation des couches peut entraîner lors de dilatations et/ou de contractions pendant la fabrication ou l'utilisation du module photovoltaïque, des contraintes pouvant conduire à des délaminations localisées, en particulier à l'interface entre la première couche formant la face avant et le reste des couches constitutives du module.

Le matériau d'encapsulation formant les deux couches de matériau d'encapsulation de cœur de l'ensemble encapsulant peut présenter un module de Young à température ambiante supérieur ou égal à 100 MPa, notamment supérieur ou égal à 150 MPa, voire 200 MPa. Il est notamment de 220 MPa.

L'ensemble encapsulant peut être formé à partir de deux couches de matériau d'encapsulation de cœur ayant des épaisseurs identiques ou différentes.

L'ensemble encapsulant peut par ailleurs être constitué d'un matériau du type ionomère, tel que le ionomère commercialisé sous le nom de ionomère jurasol® de type DG3 par la société Jura-plast ou le ionomère commercialisé sous le nom de PV5414 par la société Du Pont, présentant un module de Young supérieur ou égal à 200 MPa à température ambiante.

La deuxième couche formant la face arrière du module photovoltaïque peut être constituée d'au moins un matériau polymère.

En variante, la deuxième couche formant la face arrière du module photovoltaïque peut être constituée d'au moins un matériau composite, notamment du type polymère/fibres de verre.

La deuxième couche a par ailleurs, de préférence, un coefficient de dilatation thermique inférieur ou égal à 20 ppm, et de préférence inférieur ou égal à 10 ppm.

La deuxième couche formant la face arrière du module photovoltaïque peut être ou non transparente.

La rigidité de la deuxième couche formant la face arrière du module photovoltaïque peut être définie par un facteur de rigidité, correspondant au module de Young à température ambiante du matériau de la deuxième couche multiplié par l'épaisseur de la deuxième couche, compris entre 5 et 15 GPa.mm.

De plus, la rigidité de la deuxième couche formant la face arrière du module photovoltaïque peut être définie par un module de Young à température ambiante du matériau de la deuxième couche supérieur ou égal à 1 GPa, mieux supérieur ou égal à 3 GPa, encore mieux supérieur ou égal à 10 GPa, et une épaisseur de la deuxième couche comprise entre 0,2 et 3 mm.

De cette façon, la deuxième couche formant la face arrière du module photovoltaïque peut présenter une rigidité élevée, pouvant limiter ainsi sa flexibilité. Toutefois, cette rigidité élevée peut permettre de réduire, voire d'empêcher, le poinçonnement des cellules photovoltaïques par la face arrière du module, c'est-à-dire l'apparition de fissures et/ou de cassures des cellules photovoltaïques, lorsque celui-ci est par exemple appliqué sur un support présentant une rugosité de surface importante.

L'espacement entre deux cellules photovoltaïques voisines, ou encore consécutives ou adjacentes, peut être supérieur ou égal à 1 mm, notamment compris entre 1 et 30 mm, et de préférence supérieur ou égal à 3 mm, notamment compris entre 10 et 20 mm.

Les deux cellules photovoltaïques voisines considérées peuvent être deux cellules voisines d'une même série (encore désignée par le terme « string » en anglais) ou deux cellules voisines appartenant respectivement à deux séries consécutives de l'ensemble de cellules photovoltaïques.

La présence d'un important espacement entre les cellules photovoltaïques peut permettre d'obtenir un espacement également important entre les plaques de la première couche formant la face avant du module photovoltaïque. De cette façon, l'aspect discontinu de la face avant du module est accentué, permettant ainsi de conférer une flexibilité au module pour faciliter son éventuelle application sur un support rigide.

De façon avantageuse, l'espacement entre deux plaques voisines de la première couche, et éventuellement de la deuxième couche, est inférieur ou égal à l'espacement entre deux cellules photovoltaïques voisines.

Selon une variante, le module photovoltaïque peut comporter une couche intermédiaire dite « amortissante » située entre la première couche formant la face avant du module photovoltaïque et l'ensemble encapsulant la pluralité de cellules photovoltaïques, permettant l'assemblage, notamment par collage, de la première couche sur l'ensemble encapsulant.

La couche intermédiaire peut être constituée d'au moins un matériau polymère, notamment d'une résine polymère thermoplastique ou thermodurcissable.

La couche intermédiaire peut se présenter par exemple sous forme de feuille ou sous forme liquide. Elle peut être adhésive, par exemple du type PSA, ou non. Elle peut être mise en œuvre à chaud ou encore à température ambiante.

La rigidité de la couche intermédiaire peut être définie par un module de Young du matériau de la couche intermédiaire inférieur ou égal à 50 MPa à température ambiante et une épaisseur de la couche intermédiaire comprise entre 0,01 et 1 mm.

La couche intermédiaire peut en particulier remplir deux fonctions principales. D'une part, elle peut permettre l'adhésion de la première couche formant la face avant du module photovoltaïque sur l'ensemble encapsulant pour le cas où les deux couches ne sont pas compatibles chimiquement. D'autre part, elle peut permettre de créer au sein du module photovoltaïque une couche « amortissante » d'une certaine souplesse permettant d'améliorer la résistance aux chocs et aux charges mécaniques du module.

Cette couche intermédiaire peut être optionnelle, en particulier absente lorsqu'il y a compatibilité chimique entre la première couche formant la face avant du module photovoltaïque et l'ensemble encapsulant.

La couche intermédiaire peut aussi jouer un rôle dans le gradient de rigidité apporté par la ou les couches de matériau d'encapsulation additionnelles. Ainsi, la couche intermédiaire peut présenter une rigidité inférieure à celle de la ou des couches de matériau d'encapsulation additionnelles.

Le module photovoltaïque peut en outre comporter une couche adhésive située entre la deuxième couche formant la face arrière du module photovoltaïque et l'ensemble encapsulant la pluralité de cellules photovoltaïques, permettant l'assemblage, notamment par collage, de la deuxième couche sur l'ensemble encapsulant.

Par « couche adhésive », on entend une couche permettant, une fois le module photovoltaïque réalisé, à la deuxième couche d'adhérer à l'ensemble encapsulant. Il s'agit ainsi d'une couche permettant une compatibilité chimique et une adhésion entre l'encapsulant et la face arrière.

Par ailleurs, l'épaisseur de la première couche formant la face avant du module photovoltaïque peut être supérieure ou égale à 0,1 mm, notamment comprise entre 0,5 et 6 mm.

En outre, l'invention a encore pour objet, selon un autre de ses aspects, un module photovoltaïque comportant au moins :
- une première couche transparente formant la face avant du module photovoltaïque destinée à recevoir un flux lumineux,
- un ensemble d'une pluralité de cellules photovoltaïques disposées côte à côte et reliées électriquement entre elles,
- un ensemble encapsulant la pluralité de cellules photovoltaïques,
- une deuxième couche formant la face arrière du module photovoltaïque, l'ensemble encapsulant et l'ensemble d'une pluralité de cellules photovoltaïques étant situés entre les première et deuxième couches,
caractérisé en ce que la première couche est constituée d'au moins un matériau polymère transparent et comporte une pluralité de plaques indépendantes les unes des autres, chaque plaque étant située en regard d'au moins une cellule photovoltaïque, de sorte à former une face avant discontinue du module photovoltaïque,
en ce que la rigidité de l'ensemble encapsulant est définie par un module de Young à température ambiante du matériau d'encapsulation supérieur ou égal à 75 MPa et une épaisseur de l'ensemble encapsulant comprise entre 0,4 et 1 mm,
et en ce que l'ensemble encapsulant est formé par deux couches de matériau d'encapsulation de cœur situées à proximité immédiate de l'ensemble de cellules photovoltaïques, respectivement de part et d'autre de l'ensemble de cellules photovoltaïques, cet ensemble encapsulant étant complété, notamment avant laminage, par une ou plusieurs autres couches de matériau d'encapsulation additionnelles, la rigidité de la ou des couches de matériau d'encapsulation additionnelles, autres que les deux couches de matériau d'encapsulation de cœur, étant décroissante en éloignement des deux couches de matériau d'encapsulation de cœur.

De plus, l'invention a encore pour objet, selon un autre de ses aspects, un ensemble de structure photovoltaïque, comportant :
- un support rigide,
- un module photovoltaïque tel que défini précédemment, et
- une couche de fixation, notamment par collage, située entre le support rigide et le module photovoltaïque, permettant l'adhérence du module photovoltaïque au support rigide.

Le support rigide peut présenter une rugosité de surface.

L'utilisation de la couche de fixation peut permettre d'obtenir une face arrière du module photovoltaïque renforcée, permettant d'éviter le risque de poinçonnement des cellules photovoltaïques par la face arrière lorsque le support rigide présente une rugosité de surface élevée et que le module photovoltaïque est soumis à un choc ou une charge mécanique élevée. En effet, l'interface entre la face arrière du module et le support rigide peut ainsi être comblée par un liant de protection.

En outre, l'invention a également pour objet, selon un autre de ses aspects, l'utilisation, pour son application sur un support rigide d'un module photovoltaïque comportant au moins :
- une première couche transparente formant la face avant du module photovoltaïque destinée à recevoir un flux lumineux,
- un ensemble d'une pluralité de cellules photovoltaïques disposées côte à côte et reliées électriquement entre elles,
- un ensemble encapsulant la pluralité de cellules photovoltaïques,
- une deuxième couche formant la face arrière du module photovoltaïque, l'ensemble encapsulant et l'ensemble d'une pluralité de cellules photovoltaïques étant situés entre les première et deuxième couches,
la première couche comportant une pluralité de plaques indépendantes les unes des autres, chaque plaque étant située en regard d'au moins une cellule photovoltaïque, de sorte à former une face avant discontinue du module photovoltaïque,
la rigidité de l'ensemble encapsulant étant définie par un module de Young du matériau d'encapsulation supérieur ou égal à 75 MPa à température ambiante et une épaisseur de l'ensemble encapsulant comprise entre 0,4 et 1 mm,
la première couche étant notamment constituée d'au moins un matériau polymère transparent faisant partie des copolymères à blocs acryliques ou d'une composition comprenant au moins un copolymère à blocs acryliques ayant la formule générale suivante :

(A)ₙB

dans laquelle :
- n est un nombre entier supérieur ou égal à 1 ;
- A est un homo- ou copolymère acrylique ou méthacrylique ayant une température de transition vitreuse supérieure à 50°C, notamment supérieure à 80°C, ou du polystyrène, ou un copolymère acrylique-styrène ou méthacrylique-styrène ; et
- B est un homo- ou copolymère acrylique ou méthacrylique ayant une température de transition vitreuse inférieure à 20°C, notamment composé d'acrylate de méthyle, d'acrylate d'éthyle, d'acrylate d'éthylhexyl, de méthacrylate de butyle ou encore d'acrylate de butyle,
et le module photovoltaïque étant appliqué sur le support rigide par l'intermédiaire d'une couche de fixation.

De façon avantageuse, la première couche peut être constituée d'au moins un matériau polymère transparent étant du polyméthacrylate de méthyle (PMMA) choc nanostructuré, lorsque A est un homo- ou copolymère méthacrylique (majoritairement méthacrylique ou acrylique à majorité de méthyl méthacrylate).

Par ailleurs, l'invention a encore pour objet, selon un autre de ses aspects, un procédé de réalisation d'un module photovoltaïque tel que défini précédemment ou d'un ensemble de structure photovoltaïque tel que défini précédemment, comportant au moins l'étape a) suivante et successivement au moins l'étape b) ou l'étape c) suivantes de
a) laminage à chaud à une température supérieure à 150°C de l'ensemble des couches constitutives du module photovoltaïque hormis la première couche formant la face avant du module photovoltaïque et une éventuelle couche intermédiaire dite « amortissante », située entre la première couche et l'ensemble encapsulant la pluralité de cellules photovoltaïques,
b) laminage à une température inférieure ou égale à 150°C, mieux 125°C, par exemple à température ambiante, de la première couche formant la face avant du module photovoltaïque, et de l'éventuelle couche intermédiaire, sur les couches constitutives du module photovoltaïque laminées ensemble au cours de la première étape a),
c) collage, avec au préalable dépôt d'une colle liquide réactive ou non, ou pressage, notamment à chaud, de la première couche formant la face avant du module photovoltaïque, et de l'éventuelle couche intermédiaire, sur les couches constitutives du module photovoltaïque laminées ensemble au cours de la première étape a).

Ainsi, les étapes b) et c) constituent deux étapes alternatives effectuées après l'étape a).

La colle liquide est préférentiellement rendue solide par évaporation de solvant, par réaction de polymérisation et/ou réticulation déclenchée par température, ou par irradiation électromagnétique. Le pressage peut être utilisé, en alternative au collage, lorsqu'il y a déjà une compatibilité chimique en termes d'adhésion entre la première couche, ou l'éventuelle couche intermédiaire, et la couche supérieure des couches laminées ensemble au cours de la première étape a).

Lors de la première étape a) de laminage, les couches constitutives du module photovoltaïque concernées sont ainsi l'ensemble d'une pluralité de cellules photovoltaïques, l'ensemble encapsulant et la deuxième couche formant la face arrière du module photovoltaïque.

L'éventuelle couche intermédiaire dite « amortissante » peut permettre de faciliter le collage de la première couche formant la face avant du module sur les autres couches. Cette couche intermédiaire est optionnelle. Elle peut notamment ne pas être nécessaire lorsqu'il existe une compatibilité chimique entre la première couche formant la face avant du module et l'ensemble encapsulant.

Avantageusement, la mise en œuvre d'au moins deux étapes de laminage dans le procédé selon l'invention pour la réalisation du module photovoltaïque peut permettre de s'affranchir d'éventuels problèmes de dilatation thermique pouvant survenir du fait de l'utilisation d'une face avant du module en un matériau polymère.

En effet, certaines couches du module photovoltaïque nécessitent d'être laminées à une température supérieure ou égale à 140°C, voire 150°C, mais le laminage à ce niveau de température en une seule étape, conformément à la pratique selon l'art antérieur, de l'ensemble des couches du module, y compris celle formant la face avant du module, peut donner lieu à une conformation non contrôlée et à des délaminations importantes de la face avant du module photovoltaïque à cause de contraintes mécaniques engendrées trop importantes.

Aussi, la présence d'au moins une deuxième étape de laminage à plus basse température que pour la première étape, pour le laminage de la face avant du module photovoltaïque, éventuellement combinée à la présence d'une couche intermédiaire dite « amortissante » permettant le collage de la face avant du module sur le matériau d'encapsulation et l'amortissement des contraintes thermiques, peuvent permettre de limiter, voire d'empêcher, la dilatation thermique.

Alternativement, l'invention a aussi pour objet, selon un autre de ses aspects, un procédé de réalisation d'un module photovoltaïque tel que défini précédemment ou d'un ensemble de structure photovoltaïque tel que défini précédemment, comportant l'unique étape suivante de :
d) laminage à chaud à une température supérieure ou égale à 150°C de l'ensemble des couches constitutives du module photovoltaïque.

Pour la réalisation d'un ensemble de structure photovoltaïque tel que défini précédemment, les étapes a) et b), ou les étapes a) et c), ou l'étape d), peuvent être suivies de l'étape e) de fixation du module photovoltaïque sur un support rigide pour former l'ensemble de structure photovoltaïque, au moyen d'une couche de fixation de l'ensemble de structure photovoltaïque.

Comme indiqué précédemment, l'épaisseur de l'ensemble encapsulant peut être comprise entre 0,4 et 1 mm, celui-ci résultant de l'association par laminage d'au moins deux couches de matériau d'encapsulation présentant chacune une épaisseur comprise entre 0,2 et 0,5 mm. Ces deux couches de matériau d'encapsulation peuvent par ailleurs présenter des épaisseurs différentes.

Le module photovoltaïque, l'ensemble de structure photovoltaïque et le procédé selon l'invention peuvent comporter l'une quelconque des caractéristiques précédemment énoncées, prises isolément ou selon toutes combinaisons techniquement possibles avec d'autres caractéristiques.

### BRÈVE DESCRIPTION DU DESSIN

L'invention pourra être mieux comprise à la lecture de la description détaillée qui va suivre, d'un exemple de mise en œuvre non limitatif de celle-ci, ainsi qu'à l'examen de la figure unique, schématique et partielle, du dessin annexé, illustrant, en coupe et en vue éclatée, un exemple de réalisation d'un ensemble de structure photovoltaïque comportant un module photovoltaïque conforme à l'invention.

Sur cette figure unique, les différentes parties représentées ne le sont pas nécessairement selon une échelle uniforme, pour rendre la figure plus lisible.

### EXPOSÉ DÉTAILLÉ D'UN MODE DE RÉALISATION PARTICULIER

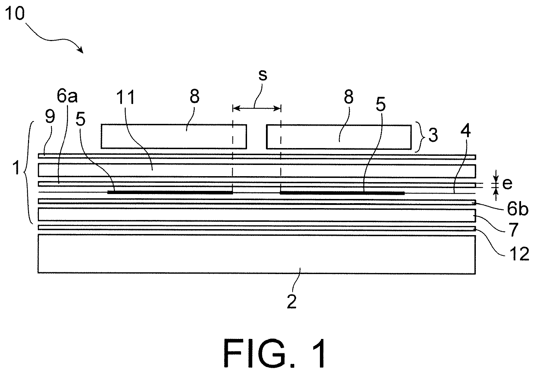

Il est à noter que la figure 1 correspond à une vue éclatée de l'ensemble 10 de structure photovoltaïque avant les étapes de laminage du procédé selon l'invention. Une fois ces étapes réalisées, les différentes couches sont en réalité superposées les unes aux autres, mais aussi un peu déformées de sorte qu'au moins les plaques 8 de la première couche 3 s'enfoncent dans l'ensemble formé par la couche intermédiaire 9 et l'ensemble encapsulant 6a, 6b qui se déforment. Les étapes de laminage assurent un pressage à chaud et sous vide. Selon les épaisseurs des différentes couches, les plaques 8 peuvent affleurer ou non sur le module photovoltaïque 1, le matériau de la couche intermédiaire 9 et peut-être celui de l'ensemble encapsulant 6a, 6b pouvant également combler au moins une partie des espaces entre les plaques 8.

Comme expliqué précédemment, le module photovoltaïque 1 conforme à l'invention est conçu pour être suffisamment flexible afin de pouvoir l'appliquer, notamment par collage, sur un éventuel support rigide 2, pouvant présenter une rugosité de surface, autrement dit pas nécessairement plan et lisse. De plus, le module photovoltaïque 1 conforme à l'invention est également prévu pour résister à des pressions statiques ou dynamiques pouvant aller jusqu'à 1500 kN/m², voire 5000 kN/m². Le support rigide 2 est de manière avantageuse suffisamment rigide pour ne pas se déformer lorsqu'on applique la même contrainte que celle appliquée au module photovoltaïque 1. Il peut par exemple être formé par un revêtement de toiture, être en béton ou en tôle métallique, entre autres.

Comme on peut ainsi le voir sur la figure 1, le module photovoltaïque 1 comporte une première couche 3 transparente formant la face avant du module 1 destinée à recevoir un flux lumineux, un ensemble encapsulant 6a, 6b, obtenu par la fusion de deux couches de matériau d'encapsulation de cœur supérieure 6a et inférieure 6b, cet ensemble encapsulant étant surmonté d'une couche de matériau d'encapsulation additionnelle 11, située au-dessus de la couche de matériau d'encapsulation de cœur supérieure 6a, un ensemble 4 de cellules photovoltaïques 5 pris entre les deux couches de matériau d'encapsulation de cœur supérieure 6a et inférieure 6b, et une deuxième couche 7 formant la face arrière du module photovoltaïque 1 destinée à être collée au support rigide 2.

Les deux couches de matériau d'encapsulation de cœur 6a et 6b formant l'ensemble encapsulant, ainsi que l'éventuelle couche intermédiaire 9 décrite par la suite, forment une structure relativement souple pouvant être réalisée à partir d'un seul matériau ou de plusieurs matériaux en cas d'incompatibilité chimique.

Conformément à l'invention, la première couche 3 est constituée d'un matériau polymère transparent du type du polyméthacrylate de méthyle (PMMA) choc nanostructuré. Il peut en particulier s'agir du PMMA choc nanostructuré commercialisé par la société ARKEMA sous la marque ShieldUp®.

De plus, la première couche 3 comporte une pluralité de plaques 8 indépendantes les unes des autres, chaque plaque 8 étant située en regard d'une cellule photovoltaïque 5, de sorte à former une face avant discontinue du module photovoltaïque 1. L'épaisseur de la première couche 3 peut être supérieure à 0,1 mm, et idéalement comprise entre 0,5 et 6 mm. Dans cet exemple, la première couche 3 est ainsi constituée de plusieurs plaques 8, de dimensions égales à 162 x 162 mm, de PMMA choc nanostructuré d'épaisseur égale à 3 mm.

Par ailleurs, de façon avantageuse, la rigidité de la couche de matériau d'encapsulation additionnelle 11 est choisie pour être plus faible que les rigidités respectives des deux couches de matériau d'encapsulation de cœur 6a, 6b. En particulier, les deux couches de matériau d'encapsulation de cœur 6a, 6b peuvent présenter un module de Young E à température ambiante supérieur à 75 MPa, avantageusement supérieur à 100 MPa, et de préférence supérieur à 200 MPa, et la couche de matériau d'encapsulation additionnelle 11 peut présenter un module de Young E à température ambiante inférieur à 75 MPa, et de préférence inférieur ou égal à 50 MPa.

Autrement dit, de façon avantageuse, le module photovoltaïque 1 est constitué d'un ensemble de couches de matériau d'encapsulation 11, 6a, 6b formant un empilement de couches dans lequel un dégradé ou gradient de rigidité est établi depuis les couches de matériau d'encapsulation de cœur 6a, 6b en contact avec l'ensemble 4 de cellules photovoltaïques 5 jusqu'à la couche de matériau d'encapsulation additionnelle 11.

Bien que dans cet exemple une seule couche de matériau d'encapsulation additionnelle 11 a été envisagée, plusieurs couches de matériau d'encapsulation additionnelles 11 peuvent en variante être empilées en superposition sur la couche de matériau d'encapsulation de cœur supérieure 6a et/ou sur la couche de matériau d'encapsulation de cœur inférieure 6b. Cet empilement est alors réalisé de telle sorte que pour chaque nouvelle couche n+1 empilée, son module de Young E à température ambiante est inférieur au module de Young E à température ambiante de la couche n précédente.

La couche de matériau d'encapsulation additionnelle 11 peut être constituée d'un matériau choisi parmi les polyoléfines thermoplastiques, et notamment les polyoléfines thermoplastiques de la gamme Apolhya® Solar Film de la société Arkema, par exemple telle que l'encapsulant Apolhya® Solar Film de grade R333A ou EXP A présentant un module de Young E compris entre 50 et 100 MPa à température ambiante et une rigidité intermédiaire entre celle du ionomère des couches de matériau d'encapsulation de cœur 6a, 6b et celle du TPU de la couche intermédiaire 9.

Par ailleurs, les cellules photovoltaïques 5 sont interconnectées électriquement les unes avec les autres avec un espacement s entre deux cellules 5 voisines compris entre 1 et 30 mm. Les cellules photovoltaïques 5 peuvent être des cellules dites « cristallines », c'est-à-dire à base de cristaux de silicium ou de polycristaux de silicium, avec une homojonction ou hétérojonction, et d'épaisseur inférieure ou égale à 250 µm. De plus, dans cet exemple, chaque plaque 8 s'étend en superposition de part et d'autre de la cellule photovoltaïque 5 sous-jacente sur une distance d'environ 3 mm, de sorte que l'espacement entre deux plaques 8 adjacentes est ici égal à l'espacement s entre deux cellules 5 voisines diminué d'environ 2 fois 3 mm, soit environ 6 mm.

En outre, la rigidité de chaque couche de matériau d'encapsulation de cœur 6a et 6b est définie par un module de Young E à température ambiante du matériau d'encapsulation supérieur ou égal à 50 MPa, de préférence supérieur ou égal à 200 MPa, et une épaisseur e de la couche 6a, 6b comprise entre 0,2 et 1 mm.

Les couches de matériau d'encapsulation de cœur 6a et 6b forment un ensemble encapsulant préférentiellement choisi pour être un ionomère tel que le ionomère commercialisé sous le nom de ionomère jurasol® de type DG3 par la société Jura-plast ou le ionomère commercialisé sous le nom de PV5414 par la société Du Pont, présentant un module de Young supérieur ou égal à 200 MPa à température ambiante et une épaisseur d'environ 500 µm.

La deuxième couche 7 formant la face arrière du module photovoltaïque 1 est quant à elle constituée par un matériau polymère tel que des résines thermodurcissables comme des résines à base époxy, transparent ou non, ou un matériau composite, par exemple du type polymère/fibres de verre.

De plus, comme on peut le voir sur la figure 1, le module photovoltaïque 1 comporte également une couche intermédiaire 9 dite « amortissante » située entre la première couche 3 et la couche de matériau d'encapsulation additionnelle 11.

La couche intermédiaire 9 est optionnelle et trouve essentiellement son utilité s'il existe une incompatibilité chimique entre la première couche 3 et la couche de matériau d'encapsulation additionnelle 11.

La couche intermédiaire 9 permet le collage de la première couche 3 sur la couche de matériau d'encapsulation additionnelle 11.

La couche intermédiaire 9 est par exemple constituée par un encapsulant standard utilisé dans le domaine du photovoltaïque, tel que le copolymère de l'éthylène-acétate de vinyle (EVA), une polyoléfine, du silicone, du polyuréthane thermoplastique, du polyvinyle de butyral, entre autres. Elle peut encore être constituée par une résine liquide de type acrylique, silicone ou polyuréthane, monocomposant ou bicomposant, réticulable à chaud, photochimiquement ou bien à froid (i.e. à température ambiante). Elle peut également être constituée par un adhésif sensible à la pression du type PSA (pour « Pressure-Sensitive Adhesive » en anglais).

Dans cet exemple, la couche intermédiaire 9 est constituée par un film thermoplastique, à savoir du polyuréthane thermoplastique connu également sous l'acronyme anglo-saxon TPU, tel que le TPU de type TPU Dureflex® A4700 commercialisé par la société Bayer ou le PX1001 commercialisé par la société American Polyfilm, d'épaisseur égale à environ 380 µm.

La couche intermédiaire 9 permet de remplir deux fonctions principales. D'une part, elle permet l'adhésion de la première couche 3 sur la couche de matériau d'encapsulation additionnelle 11 pour le cas où les deux couches ne sont pas compatibles chimiquement. D'autre part, elle permet de créer au sein du module photovoltaïque 1 une couche « amortissante » d'une certaine souplesse permettant d'améliorer la résistance aux chocs et aux charges mécaniques du module 1.

Par ailleurs, l'ensemble 10 de structure photovoltaïque conforme à l'invention représenté sur la figure 1 comporte également un support rigide 2. Le support rigide 2 peut être de tout type de matière. Il peut être plan ou courbé, lisse ou rugueux.

Afin de permettre le collage du module photovoltaïque 1 sur le support rigide 2, l'ensemble 10 comporte également une couche de fixation 12. Cette couche de fixation 12 est constituée par une colle d'adhérence du module 1 au support rigide 2.

On va maintenant décrire un procédé de réalisation d'un module photovoltaïque 1 et d'un ensemble 10 de structure photovoltaïque conforme à l'invention.

Le procédé comporte une première étape a) de laminage à chaud à une température d'environ 170°C et sous vide (pression inférieure ou égale à 10 mbar) des couches constitutives 11, 6a, 4, 6b et 7 du module photovoltaïque 1 hormis la première couche 3 et la couche intermédiaire 9. Cette première étape a) de laminage est réalisée pendant environ 15 minutes de manière à obtenir un « laminé » de cellules photovoltaïques 5 encapsulées. Les paramètres du laminage, tels que la température, le temps et la pression, peuvent toutefois dépendre du matériau encapsulant utilisé.

Puis, le procédé comporte une deuxième étape b) de laminage à chaud à une température d'environ 125°C et sous vide du « laminé » obtenu au cours de la première étape a) avec la première couche 3 formant la face avant du module photovoltaïque 1 à l'aide de la couche intermédiaire 9. Cette deuxième étape b) est réalisée pendant une durée d'environ 30 minutes de façon à obtenir le module photovoltaïque 1 selon l'invention. Avant la mise en œuvre de cette deuxième étape b), les plaques 8 de la première couche 3 peuvent avantageusement être traitées à l'aide d'un équipement de traitement Corona de manière à obtenir une énergie de surface supérieure ou égale à 48 dyn/cm.

Ces première a) et deuxième b) étapes de laminage sont ensuite suivies d'une étape de fixation du module photovoltaïque 1 sur le support rigide 2 qui permet de former l'ensemble 10 de structure photovoltaïque.

Par conséquent, le module photovoltaïque 1 conforme à l'invention peut présenter une résistance mécanique accrue adaptée à des applications contraignantes en termes de sollicitations mécaniques, mais également présenter une flexibilité par morceaux du fait de la présence d'une face avant 3 discontinue, lui permettant de prendre différentes formes pour s'adapter à différents types de surfaces, par exemple accidentées ou de planéité imparfaite. De plus, la présence d'une face arrière 7 renforcée peut permettre d'améliorer la résistance au poinçonnement de cette face arrière 7 du module 1, ce poinçonnement pouvant résulter de la rugosité du support 2 sur lequel le module 1 est appliqué et pouvant conduire à des fissures des cellules photovoltaïques 5 du module photovoltaïque 1.

Bien entendu, l'invention n'est pas limitée à l'exemple de réalisation qui vient d'être décrit. Diverses modifications peuvent y être apportées par l'homme du métier, sans s'écarter de la portée des revendications.

L'expression « comportant un » doit être comprise comme étant synonyme de « comportant au moins un », sauf si le contraire est spécifié.

## Revendications

1. Module photovoltaïque (1) comportant au moins :
- une première couche (3) transparente formant la face avant du module photovoltaïque (1) destinée à recevoir un flux lumineux,
- un ensemble (4) d'une pluralité de cellules photovoltaïques (5) disposées côte à côte et reliées électriquement entre elles,
- un ensemble encapsulant (6a, 6b) la pluralité de cellules photovoltaïques (5),
- une deuxième couche (7) formant la face arrière du module photovoltaïque (1), l'ensemble encapsulant (6a, 6b) et l'ensemble (4) d'une pluralité de cellules photovoltaïques (5) étant situés entre les première (3) et deuxième (7) couches, la première couche (3) comportant une pluralité de plaques (8) indépendantes les unes des autres, chaque plaque (8) étant située en regard d'au moins une cellule photovoltaïque (5), de sorte à former une face avant discontinue du module photovoltaïque (1), **caractérisé en ce que** la rigidité de l'ensemble encapsulant (6a, 6b) est définie par un module de Young (E) du matériau d'encapsulation supérieur ou égal à 75 MPa à température ambiante et une épaisseur (e) de l'ensemble encapsulant (6a, 6b) comprise entre 0,4 et 1 mm,
et **en ce que** la première couche (3) est constituée d'au moins un matériau polymère transparent faisant partie des copolymères à blocs acryliques ou d'une composition comprenant au moins un copolymère à blocs acryliques ayant la formule générale suivante :
(A)ₙB
dans laquelle :
- n est un nombre entier supérieur ou égal à 1 ;
- A est un homo- ou copolymère acrylique ou méthacrylique ayant une température de transition vitreuse (Tg) supérieure à 50°C, notamment supérieure à 80°C, ou du polystyrène, ou un copolymère acrylique-styrène ou méthacrylique-styrène ; et
- B est un homo- ou copolymère acrylique ou méthacrylique ayant une température de transition vitreuse (Tg) inférieure à 20°C, notamment composé d'acrylate de méthyle, d'acrylate d'éthyle, d'acrylate d'éthylhexyl, de méthacrylate de butyle ou encore d'acrylate de butyle.

2. Module selon la revendication 1, **caractérisé en ce que** le bloc A est choisi parmi du polyméthacrylate de méthyle, du polyméthacrylate de phényle, du polyméthacrylate de benzyle ou du polyméthacrylate d'isobornyle, ou un copolymère à base de deux ou plus des monomères méthacrylate de méthyle, méthacrylate de phényle, méthacrylate de benzyle ou méthacrylate d'isobornyle, le bloc A étant notamment du polyméthacrylate de méthyle modifié avec des comonomères acryliques ou méthacryliques.

3. Module selon la revendication 1 ou 2, **caractérisé en ce que** le bloc A et/ou le bloc B comportent des comonomères styréniques, acryliques ou méthacryliques.

4. Module selon l'une quelconque des revendications précédentes, **caractérisé en ce que** le bloc B incorpore des comonomères, tels que le styrène, et **en ce que** le bloc A incorpore de l'acide méthacrylique.

5. Module selon l'une quelconque des revendications précédentes, **caractérisé en ce que** l'ensemble encapsulant (6a, 6b) est formé, notamment avant laminage, par deux couches de matériau d'encapsulation de cœur (6a, 6b) situées à proximité immédiate de l'ensemble (4) de cellules photovoltaïques (5), respectivement de part et d'autre de l'ensemble (4) de cellules photovoltaïques (5).

6. Module selon l'une quelconque des revendications précédentes, **caractérisé en ce que** le matériau d'encapsulation des couches formant l'ensemble encapsulant (6a, 6b) présente un module de Young (E) à température ambiante supérieur ou égal à 100 MPa, de préférence supérieur ou égal à 150 MPa, de préférence supérieur ou égal à 200 MPa, notamment égal à 220 MPa.

7. Module selon l'une quelconque des revendications précédentes, **caractérisé en ce que** l'ensemble encapsulant (6a, 6b) est complété, notamment avant laminage, par une ou plusieurs autres couches de matériau d'encapsulation additionnelles (11), la rigidité de la ou des couches de matériau d'encapsulation additionnelles (11) étant décroissante en éloignement de l'ensemble encapsulant (6a, 6b).

8. Module selon l'une des revendications 5 et 6 et selon la revendication 7, **caractérisé en ce qu'**il comporte au moins une couche de matériau d'encapsulation additionnelle (11), située entre la première couche (3) et la couche de matériau d'encapsulation de cœur (6a) à proximité immédiate, ladite au moins une couche de matériau d'encapsulation additionnelle (11) présentant notamment un module de Young (E) à température ambiante inférieur à 75 MPa.

9. Module selon la revendication 7 ou 8, **caractérisé en ce que** la ou les couches de matériau d'encapsulation additionnelles (11) sont constituées d'un matériau choisi parmi les polyoléfines thermoplastiques, la ou les couches de matériau d'encapsulation additionnelles (11) étant notamment constituées par des polyoléfines thermoplastiques fonctionnelles à base de greffons de polyamide, greffés sur un squelette polyoléfine fonctionnelle majoritaire en motifs éthylène.

10. Module selon l'une quelconque des revendications précédentes, **caractérisé en ce que** la deuxième couche (7) formant la face arrière du module photovoltaïque (1) est constituée d'au moins un matériau polymère et/ou d'au moins un matériau composite, notamment du type polymère/fibres de verre.

11. Module selon l'une quelconque des revendications précédentes, **caractérisé en ce que** la rigidité de la deuxième couche (7) formant la face arrière du module photovoltaïque (1) est définie par un facteur de rigidité, correspondant au module de Young (E) à température ambiante du matériau de la deuxième couche (7) multiplié par l'épaisseur de la deuxième couche (7), compris entre 5 et 15 GPa.mm.

12. Module selon l'une quelconque des revendications précédentes, **caractérisé en ce qu'**il comporte une couche intermédiaire (9) dite « amortissante » située entre la première couche (3) formant la face avant du module photovoltaïque (1) et l'ensemble encapsulant (6a, 6b) la pluralité de cellules photovoltaïques (5), permettant l'assemblage, notamment par collage, de la première couche (3) sur l'ensemble encapsulant (6a, 6b), la couche intermédiaire (9) étant notamment constituée d'au moins un matériau polymère, notamment d'une résine polymère thermoplastique ou thermodurcissable, la rigidité de la couche intermédiaire (9) étant notamment définie par un module de Young (E) à température ambiante du matériau de la couche intermédiaire (9) inférieur ou égal à 50 MPa et une épaisseur de la couche intermédiaire (9) comprise entre 0,01 et 1 mm.

13. Ensemble (10) de structure photovoltaïque, comportant :
- un support rigide (2),
- un module photovoltaïque (1) selon l'une quelconque des revendications précédentes, et
- une couche de fixation (12) située entre le support rigide (2) et le module photovoltaïque (1), permettant l'adhérence du module photovoltaïque (1) au support rigide (2).

14. Utilisation, pour son application sur un support rigide (2) d'un module photovoltaïque (1) comportant au moins :
- une première couche (3) transparente formant la face avant du module photovoltaïque (1) destinée à recevoir un flux lumineux,
- un ensemble (4) d'une pluralité de cellules photovoltaïques (5) disposées côte à côte et reliées électriquement entre elles,
- un ensemble encapsulant (6a, 6b) la pluralité de cellules photovoltaïques (5),
- une deuxième couche (7) formant la face arrière du module photovoltaïque (1), l'ensemble encapsulant (6a, 6b) et l'ensemble (4) d'une pluralité de cellules photovoltaïques (5) étant situés entre les première (3) et deuxième (7) couches,
la première couche (3) comportant une pluralité de plaques (8) indépendantes les unes des autres, chaque plaque (8) étant située en regard d'au moins une cellule photovoltaïque (5), de sorte à former une face avant discontinue du module photovoltaïque (1),
la rigidité de l'ensemble encapsulant (6a, 6b) étant définie par un module de Young (E) du matériau d'encapsulation supérieur ou égal à 75 MPa à température ambiante et une épaisseur (e) de l'ensemble encapsulant (6a, 6b) comprise entre 0,4 et 1 mm,
la première couche (3) étant constituée d'au moins un matériau polymère transparent faisant partie des copolymères à blocs acryliques ou d'une composition comprenant au moins un copolymère à blocs acryliques ayant la formule générale suivante :
(A)ₙB
dans laquelle :
- n est un nombre entier supérieur ou égal à 1 ;
- A est un homo- ou copolymère acrylique ou méthacrylique ayant une température de transition vitreuse (Tg) supérieure à 50°C, notamment supérieure à 80°C, ou du polystyrène, ou un copolymère acrylique-styrène ou méthacrylique-styrène ; et
- B est un homo- ou copolymère acrylique ou méthacrylique ayant une température de transition vitreuse (Tg) inférieure à 20°C, notamment composé d'acrylate de méthyle, d'acrylate d'éthyle, d'acrylate d'éthylhexyl, de méthacrylate de butyle ou encore d'acrylate de butyle,
et le module photovoltaïque (1) étant appliqué sur le support rigide (2) par l'intermédiaire d'une couche de fixation (12).

15. Procédé de réalisation d'un module photovoltaïque (1) selon l'une quelconque des revendications 1 à 13, comportant :
- au moins l'étape a) suivante et successivement au moins l'étape b) ou l'étape c) suivantes de :
a) laminage à chaud à une température supérieure à 150°C de l'ensemble des couches (11, 6a, 4, 6b, 7) constitutives du module photovoltaïque (1) hormis la première couche (3) formant la face avant du module photovoltaïque (1) et une éventuelle couche intermédiaire (9) dite « amortissante », située entre la première couche (3) et l'ensemble encapsulant (6a, 6b) la pluralité de cellules photovoltaïques (5),
b) laminage à une température inférieure ou égale à 150°C, de préférence 125°C, de la première couche (3) formant la face avant du module photovoltaïque (1), et de l'éventuelle couche intermédiaire (9), sur les couches (11, 6a, 4, 6b, 7) constitutives du module photovoltaïque (1) laminées ensemble au cours de la première étape a),
c) collage, avec au préalable dépôt d'une colle liquide réactive ou non, ou pressage, notamment à chaud, de la première couche (3) formant la face avant du module photovoltaïque (1), et de l'éventuelle couche intermédiaire (9), sur les couches (11, 6a, 4, 6b, 7) constitutives du module photovoltaïque (1) laminées ensemble au cours de la première étape a),
ou,
l'unique étape suivante de :
d) laminage à chaud à une température supérieure ou égale à 150°C de l'ensemble des couches (3, 9, 11, 6a, 4, 6b, 7) constitutives du module photovoltaïque (1).

## Patentansprüche

1. Photovoltaisches Modul (1), zumindest enthaltend:
- eine transparente erste Schicht (3), die die Vorderseite des photovoltaischen Moduls (1) bildet und dazu bestimmt ist, einen Lichtstrom zu empfangen,
- eine Anordnung (4) aus einer Vielzahl von nebeneinander angeordneten und elektrisch miteinander verbundenen photovoltaischen Zellen (5),
- eine Einkapselungsanordnung (6a, 6b), die die Vielzahl von photovoltaischen Zellen (5) einkapselt,
- eine zweite Schicht (7), die die Rückseite des photovoltaischen Moduls (1) bildet, wobei die Einkapselungsanordnung (6a, 6b) und die Anordnung (4) der Vielzahl von photovoltaischen Zellen (5) zwischen der ersten (3) und der zweiten (7) Schicht liegen,
wobei die erste Schicht (3) eine Vielzahl von voneinander unabhängigen Platten (8) enthält, wobei jede Platte (8) zumindest einer photovoltaischen Zelle (5) gegenüberliegend angeordnet ist, so dass eine diskontinuierliche Vorderseite des photovoltaischen Moduls (1) gebildet wird,
**dadurch gekennzeichnet, dass**
die Steifigkeit der Einkapselungsanordnung (6a, 6b) durch einen Elastizitätsmodul (E) des Einkapselungsmaterials größer oder gleich 75 MPa bei Raumtemperatur und eine Dicke (e) der Einkapselungsanordnung (6a, 6b) zwischen 0,4 und 1 mm definiert ist,
und dass die erste Schicht (3) aus zumindest einem transparenten polymeren Material, das zu den Acrylblockcopolymeren gehört, oder aus einer Zusammensetzung besteht, die zumindest ein Acrylblockcopolymer mit der folgenden allgemeinen Formel enthält:
(A)ₙB
worin:
- n eine ganze Zahl größer oder gleich 1 ist;
- A ein Acryl- oder Methacryl-Homo- oder -Copolymer mit einer Glasübergangstemperatur (Tg) von über 50°C, insbesondere über 80°C, oder Polystyrol oder ein Acryl-Styrol- oder Methacryl-Styrol-Copolymer ist; und
- B ein Acryl- oder Methacryl-Homo- oder -Copolymer mit einer Glasübergangstemperatur (Tg) von unter 20°C ist, das insbesondere aus Methylacrylat, Ethylacrylat, Ethylhexylacrylat, Butylmethacrylat oder Butylacrylat besteht.

2. Modul nach Anspruch 1, **dadurch gekennzeichnet, dass** Block A ausgewählt ist aus Polymethylmethacrylat, Polyphenylmethacrylat, Polybenzylmethacrylat oder Polyisobornylmethacrylat oder einem Copolymer auf Basis von zwei oder mehreren der Monomere aus Methylmethacrylat, Phenylmethacrylat, Benzylmethacrylat oder Isobornylmethacrylat, wobei Block A insbesondere mit acrylischen oder methacrylischen Comonomeren modifiziertes Polymethylmethacrylat ist.

3. Modul nach Anspruch 1 oder 2, wobei Block A und/oder Block B styrolische, acrylische oder methacrylische Comonomere enthalten.

4. Modul nach einem der vorhergehenden Ansprüche, **dadurch gekennzeichnet, dass** Block B Comonomere, wie Styrol, enthält und dass Block A Methacrylsäure enthält.

5. Modul nach einem der vorhergehenden Ansprüche, **dadurch gekennzeichnet, dass** die Einkapselungsanordnung (6a, 6b) insbesondere vor dem Laminieren aus zwei Kernschichten aus Einkapselungsmaterial (6a, 6b) gebildet ist, die sich in unmittelbarer Nähe der Anordnung (4) von photovoltaischen Zellen (5) auf der einen und der andere Seite der Anordnung (4) von photovoltaischen Zellen (5) befinden.

6. Modul nach einem der vorhergehenden Ansprüche, **dadurch gekennzeichnet, dass** das Einkapselungsmaterial der die Einkapselungsanordnung (6a, 6b) bildenden Schichten einen ElastizitätsModul (E) bei Raumtemperatur größer oder gleich 100 MPa, vorzugsweise größer oder gleich 150 MPa, vorzugsweise größer oder gleich 200 MPa, insbesondere gleich 220 MPa, aufweist.

7. Modul nach einem der vorhergehenden Ansprüche, **dadurch gekennzeichnet, dass** die Einkapselungsanordnung (6a, 6b) insbesondere vor dem Laminieren mit einer oder mehreren weiteren Zusatzschichten aus Einkapselungsmaterial (11) ergänzt ist, wobei die Steifigkeit der Zusatzschicht(en) aus Einkapselungsmaterial (11) von der Einkapselungsanordnung (6a, 6b) weg abnimmt.

8. Modul nach einem der Ansprüche 5 und 6 und nach Anspruch 7, **dadurch gekennzeichnet, dass** es zumindest eine Zusatzschicht aus Einkapselungsmaterial (11) enthält, die sich in unmittelbarer Nähe zwischen der ersten Schicht (3) und der Einkapselungsmaterial-Kernschicht (6a) befindet, wobei die zumindest eine Zusatzschicht aus Einkapselungsmaterial (11) einen Elastizitätsmodul (E) bei Raumtemperatur von unter 75 MPa aufweist.

9. Modul nach Anspruch 7 oder 8, **dadurch gekennzeichnet, dass** die Zusatzschicht(en) aus Einkapselungsmaterial (11) aus einem Material, ausgewählt aus thermoplastischen Polyolefinen, bestehen, wobei die Zusatzschicht(en) aus Einkapselungsmaterial (11) insbesondere aus thermoplastischen funktionellen Polyolefinen auf Basis von Polyamidpfropfungen auf ein überwiegend aus Ethyleneinheiten aufgebautes funktionelles Polyolefingerüst bestehen.

10. Modul nach einem der vorhergehenden Ansprüche, **dadurch gekennzeichnet, dass** die zweite Schicht (7), die die Rückseite des photovoltaischen Moduls (1) bildet, aus zumindest einem Polymermaterial und/oder zumindest einem Verbundmaterial, insbesondere vom Typ Polymer/Glasfaser, besteht.

11. Modul nach einem der vorhergehenden Ansprüche, **dadurch gekennzeichnet, dass** die Steifigkeit der zweiten Schicht (7), die die Rückseite des photovoltaischen Moduls (1) bildet, durch einen Steifigkeitsfaktor, der dem Elastizitätsmodul (E) bei Raumtemperatur des Materials der zweiten Schicht (7) multipliziert mit der Dicke der zweiten Schicht (7) entspricht, zwischen 5 und 15 GPa.mm definiert ist.

12. Modul nach einem der vorhergehenden Ansprüche, **dadurch gekennzeichnet, dass** es eine sogenannte "abfedernde" Zwischenschicht (9) enthält, die sich zwischen der ersten Schicht (3), die die Vorderseite des photovoltaischen Moduls (1) bildet, und der Einkapselungsanordnung (6a, 6b), die die Vielzahl von photovoltaischen Zellen (5) einkapselt, befindet und das Anfügen, insbesondere durch Verkleben, der ersten Schicht (3) an die Einkapselungsanordnung (6a, 6b) ermöglicht, wobei die Zwischenschicht (9) insbesondere aus zumindest einem Polymermaterial, insbesondere einem thermoplastischen oder duroplastischen Polymerharz, besteht, wobei die Steifigkeit der Zwischenschicht (9) insbesondere durch einen Elastizitätsmodul (E) bei Raumtemperatur des Materials der Zwischenschicht (9) kleiner oder gleich 50 MPa und eine Dicke der Zwischenschicht (9) zwischen 0,01 und 1 mm definiert ist.

13. Photovoltaische Strukturanordnung (10), enthaltend:
- einen starren Träger (2),
- ein photovoltaisches Modul (1) nach einem der vorhergehenden Ansprüche und
- eine Befestigungsschicht (12), die sich zwischen dem starren Träger (2) und dem photovoltaischen Modul (1) befindet und das Anhaften des photovoltaischen Moduls (1) an dem starren Träger (2) ermöglicht.

14. Verwendung eines photovoltaischen Moduls (1) zu dessen Aufbringung auf einen starren Träger (2), zumindest enthaltend:
- eine transparente erste Schicht (3), die die Vorderseite des photovoltaischen Moduls (1) bildet und dazu bestimmt ist, einen Lichtstrom zu empfangen,
- eine Anordnung (4) aus einer Vielzahl von nebeneinander angeordneten und elektrisch miteinander verbundenen photovoltaischen Zellen (5),
- eine Einkapselungsanordnung (6a, 6b), die die Vielzahl von photovoltaischen Zellen (5) einkapselt,
- eine zweite Schicht (7), die die Rückseite des photovoltaischen Moduls (1) bildet, wobei die Einkapselungsanordnung (6a, 6b) und die Anordnung (4) der Vielzahl von photovoltaischen Zellen (5) zwischen der ersten (3) und der zweiten (7) Schicht liegen,
wobei die erste Schicht (3) eine Vielzahl von voneinander unabhängigen Platten (8) umfasst, wobei jede Platte (8) zumindest einer photovoltaischen Zelle (5) gegenüberliegend angeordnet ist, so dass eine diskontinuierliche Vorderseite des photovoltaischen Moduls (1) gebildet wird,
wobei die Steifigkeit der Einkapselungsanordnung (6a, 6b) durch einen Elastizitätsmodul (E) des Einkapselungsmaterials größer oder gleich 75 MPa bei Raumtemperatur und eine Dicke (e) der Einkapselungsanordnung (6a, 6b) zwischen 0,4 und 1 mm definiert ist,
wobei die erste Schicht (3) aus zumindest einem transparenten Polymermaterial, das zu den Acrylblockcopolymeren gehört, oder aus einer Zusammensetzung besteht, die zumindest ein Acrylblockcopolymer mit der folgenden allgemeinen Formel enthält:
(A)ₙB
worin:
- n eine ganze Zahl größer oder gleich 1 ist;
- A ein Acryl- oder Methacryl-Homo- oder -Copolymer mit einer Glasübergangstemperatur (Tg) von über 50°C, insbesondere über 80°C, oder Polystyrol oder ein Acryl-Styrol- oder Methacryl-Styrol-Copolymer ist; und
- B ein Acryl- oder Methacryl-Homo- oder Copolymer mit einer Glasübergangstemperatur (Tg) von unter 20°C, insbesondere bestehend aus Methylacrylat, Ethylacrylat, Ethylhexylacrylat, Butylmethacrylat oder Butylacrylat, ist,
und wobei das photovoltaische Modul (1) mittels einer Befestigungsschicht (12) auf den starren Träger (2) aufgebracht ist.

15. Verfahren zur Herstellung eines photovoltaischen Moduls (1) nach einem der Ansprüche 1 bis 13, umfassend:
- zumindest den folgenden Schritt a) und nacheinander zumindest den folgenden Schritt b) oder Schritt c):
a) Heißlaminieren bei einer Temperatur über 150°C aller Schichten (11, 6a, 4, 6b, 7), die das photovoltaische Modul (1) bilden, mit Ausnahme der ersten Schicht (3), die die Vorderseite des photovoltaischen Moduls (1) bildet, und einer eventuellen, sogenannten "abfedernden" Zwischenschicht (9), die sich zwischen der ersten Schicht (3) und der Einkapselungsanordnung (6a, 6b), die die Vielzahl von photovoltaischen Zellen (5) einkapselt, befindet,
b) Auflaminieren bei einer Temperatur von unter oder gleich 150°C, vorzugsweise 125°C, der ersten Schicht (3), die die Vorderseite des photovoltaischen Moduls (1) bildet, und der eventuellen Zwischenschicht (9), auf die Schichten (11, 6a, 4, 6b, 7), die das im ersten Schritt a) zusammenlaminierte photovoltaische Modul (1) bilden,
c) Aufkleben, unter vorherigem Auftragen eines reaktiven oder nicht reaktiven Flüssigklebers, oder Aufpressen, insbesondere Heißpressen, der ersten Schicht (3), die die Vorderseite des photovoltaischen Moduls (1) bildet, und der eventuellen Zwischenschicht (9) auf die Schichten (11, 6a, 4, 6b, 7), die das photovoltaische Modul (1) bilden, das im ersten Schritt a) zusammenlaminiert wurde,
oder
- den folgenden Einzelschritt:
d) Heißlaminieren aller Schichten (3, 9, 11, 6a, 4, 6b, 7), die das photovoltaische Modul (1) bilden, bei einer Temperatur von über oder gleich 150°C.

## Claims

1. Photovoltaic module (1) comprising at least:
- a transparent first layer (3) forming the front face of the photovoltaic module (1) intended to receive a luminous flux,
- a set (4) of a plurality of photovoltaic cells (5) arranged side-by-side and connected together electrically,
- an assembly (6a, 6b) encapsulating the plurality of photovoltaic cells (5),
- a second layer (7) forming the rear face of the photovoltaic module (1), the encapsulating assembly (6a, 6b) and the set (4) of a plurality of photovoltaic cells (5) being located between the first (3) and second (7) layers,
the first layer (3) comprising a plurality of plates (8) independent from each other, each plate (8) being located opposite at least one photovoltaic cell (5), in such a way as to form a discontinuous front face of the photovoltaic module (1),
**characterised in that** the rigidity of the encapsulating assembly (6a, 6b) is defined by a Young's modulus (E) of the encapsulation material greater than or equal to 75 MPa at ambient temperature and a thickness (e) of the encapsulating assembly (6a, 6b) of between 0.4 and 1 mm,
and **in that** the first layer (3) consists of at least one transparent polymer material belonging to the acrylic block copolymers or of a composition comprising at least one acrylic block copolymer having the following general formula:
(A)ₙB
wherein:
- n is an integer greater than or equal to 1;
- A is an acrylic or methacrylic homo- or copolymer having a glass transition temperature (Tg) greater than 50°C, in particular greater than 80°C, or polystyrene, or an acrylic-styrene or methacrylic-styrene copolymer; and
- B is an acrylic or methacrylic homo- or copolymer having a glass transition temperature (Tg) less than 20°C, in particular comprised of methyl acrylate, ethyl acrylate, ethylhexyl acrylate, butyl methylacrylate or butyl acrylate.

2. Module according to claim 1, **characterised in that** the block A is chosen from polymethyl methacrylate, phenyl polymethylacrylate, benzyl polymethylacrylate or isobornyl polymethylacrylate, or a copolymer with a base of two or more of methyl methacrylate monomers, phenyl methacrylate, benzyl methacrylate or isobornyl methacrylate, the block A being of the polymethyl methacrylate modified with acrylic or methacrylic comonomers.

3. Module according to claim 1 or 2, **characterised in that** the block A and/or the block B comprise styrene, acrylic or methacrylic comonomers.

4. Module as claimed in any preceding claim, **characterised in that** the block B incorporates comonomers, such as styrene, and **in that** the block A incorporates methacrylic acid.

5. Module as claimed in any preceding claim, **characterised in that** the encapsulating assembly (6a, 6b) is formed, in particular before laminating, by two core layers of encapsulation material (6a, 6b) located in the immediate vicinity of the set (4) of photovoltaic cells (5), respectively on either side of the set (4) of photovoltaic cells (5).

6. Module as claimed in any preceding claim, **characterised in that** the encapsulation material of the layers forming the encapsulating assembly (6a, 6b) has a Young's modulus (E) at ambient temperature greater than or equal to 100 MPa, preferably greater than or equal to 150 MPa, preferably greater than or equal to 200 MPa, in particular equal to 220 MPa.

7. Module as claimed in any preceding claim, **characterised in that** the encapsulating assembly (6a, 6b) is supplemented, in particular before laminating, with one or more other additional layers of encapsulation material (11), the rigidity of the additional layer or layers of encapsulation material (11) decreasing when moving away from the encapsulating assembly (6a, 6b).

8. Module according to one of claims 5 and 6 and according to claim 7, **characterised in that** it comprises at least one additional layer of encapsulation material (11), located between the first layer (3) and the core layer of encapsulation material (6a) in the immediate vicinity, said at least one additional layer of encapsulation material (11) having in particular a Young's modulus (E) at ambient temperature less than 75 MPa.

9. Module according to claim 7 or 8, **characterised in that** the additional layer or layers of encapsulation material (11) are comprised of a material chosen from thermoplastic polyolefins, the additional layer or layers of encapsulation material (11) being in particular comprised of functional thermoplastic polyolefins with a polyamide graft base, grafted onto a functional polyolefin backbone with ethylene units.

10. Module as claimed in any preceding claim, **characterised in that** the second layer (7) forming the rear face of the photovoltaic module (1) is comprised of at least one polymer material and/or of at least one composite material, in particular of the polymer/glass fibre type.

11. Module as claimed in any preceding claim, **characterised in that** the rigidity of the second layer (7) forming the rear face of the photovoltaic module (1) is defined by a factor of rigidity, corresponding to the Young's modulus (E) at ambient temperature of the material of the second layer (7) multiplied by the thickness of the second layer (7), between 5 and 15 GPa.mm.

12. Module as claimed in any preceding claim, **characterised in that** it comprises a so-called "shock-absorbing" intermediate layer (9) located between the first layer (3) forming the front face of the photovoltaic module (1) and the assembly (6a, 6b) encapsulating the plurality of photovoltaic cells (5), allowing for the assembly, in particular by gluing, of the first layer (3) on the encapsulating assembly (6a, 6b), the intermediate layer (9) being in particular comprised of at least one polymer material, in particular of a thermosetting or thermoplastic polymer resin, the rigidity of the intermediate layer (9) being in particular defined by a Young's modulus (E) at ambient temperature of the material of the intermediate layer (9) less than or equal to 50 MPa and a thickness of the intermediate layer (9) between 0.01 and 1 mm.

13. Photovoltaic structure assembly (10), comprising:
- a rigid support (2),
- a photovoltaic module (1) as claimed in any preceding claim, and
- a fixing layer (12) located between the rigid support (2) and the photovoltaic module (1), allowing for the adherence of the photovoltaic module (1) to the rigid support (2).

14. Use, for the application thereof on a rigid support (2) of a photovoltaic module (1) comprising at least:
- one transparent first layer (3) forming the front face of the photovoltaic module (1) intended to receive a luminous flux,
- a set (4) of a plurality of photovoltaic cells (5) arranged side-by-side and connected together electrically,
- an assembly (6a, 6b) encapsulating the plurality of photovoltaic cells (5),
- a second layer (7) forming the rear face of the photovoltaic module (1), the encapsulating assembly (6a, 6b) and the set (4) of a plurality of photovoltaic cells (5) being located between the first (3) and second (7) layers,
the first layer (3) comprising a plurality of plates (8) independent from each other, each plate (8) being located opposite at least one photovoltaic cell (5), in such a way as to form a discontinuous front face of the photovoltaic module (1),
the rigidity of the encapsulating assembly (6a, 6b) being defined by a Young's modulus (E) of the encapsulation material greater than or equal to 75 MPa at ambient temperature and a thickness (e) of the encapsulating assembly (6a, 6b) of between 0.4 and 1 mm,
the first layer (3) being comprised of at least one transparent polymer material belonging to the acrylic block copolymers or of a composition comprising at least one acrylic block copolymer having the following general formula:
(A)ₙB
wherein:
- n is an integer greater than or equal to 1;
- A is an acrylic or methacrylic homo- or copolymer having a glass transition temperature (Tg) greater than 50°C, in particular greater than 80°C, or polystyrene, or an acrylic-styrene or methacrylic-styrene copolymer; and
- B is an acrylic or methacrylic homo- or copolymer having a glass transition temperature (Tg) less than 20°C, in particular comprised of methyl acrylate, ethyl acrylate, ethylhexyl acrylate, butyl methylacrylate or butyl acrylate,
and the photovoltaic module (1) being applied on the rigid support (2) by the intermediary of a fixing layer (12).

15. Method for carrying out a photovoltaic module (1) according to any of claims 1 to 13, comprising at least the following step a) and successively at least the following step b) or the step c) of:
a) hot laminating at a temperature greater than 150°C of the set of layers (11, 6a, 4, 6b, 7) that comprise the photovoltaic module (1) other than the first layer (3) forming the front face of the photovoltaic module (1) and a possible so-called "shock-absorbing" intermediate layer (9), located between the first layer (3) and the encapsulating assembly (6a, 6b) the plurality of photovoltaic cells (5),
b) laminating at a temperature less than or equal to 150°C, more preferably 125°C, of the first layer (3) forming the front face of the photovoltaic module (1), and of the possible intermediate layer (9), on the layers (11, 6a, 4, 6b, 7) that comprise the photovoltaic module (1) laminated together during the first step a),
c) gluing, with beforehand depositing of a liquid glue whether or not reactive, or pressing, in particular hot pressing, of the first layer (3) forming the front face of the photovoltaic module (1), and of the possible intermediate layer (9), on the layers (11, 6a, 4, 6b, 7) that comprise the photovoltaic module (1) laminated together during the first step a),
or the single following step of:
d) hot laminating at a temperature greater than or equal to 150°C of all of the layers (3, 9, 11, 6a, 4, 6b, 7) that comprise the photovoltaic module (1).
